# FASCICULE DE BREVET EUROPEEN

(11) **EP 1 514 461 B1**
(45) Date de publication et mention de la délivrance du brevet: **13.10.2010**
(21) Numéro de dépôt: 03720074.8
(22) Date de dépôt: 19.05.2003
(51) Int. Cl.: H05K 13/04, B65G 47/84

(54) **METHODE POUR L'AJUSTEMENT DES SUPPORTS D'UN BARILLET ET BARILLET**
VERFAHREN ZUR LAGEREGELUNG EINES BAUTEILTRÄGERS AN EINER ROTIERENDEN BESTÜCKUNGSVORRICHTUNG UND EINSTELLBARE BESTÜCKUNGSVORRICHTUNG
METHOD FOR ADJUSTING A ROTARY DRUM SUPPORTS AND ROTARY DRUM

(30) Priorité: 14.06.2002 CH 101402
(43) Date de publication de la demande: 16.03.2005
(73) Titulaire: ISMECA Semiconductor Holding SA, 2300 La Chaux-de-Fonds (CH)
(72) Inventeur: DROMARD, Pascal, F-25500 Montlebon (FR); MATHEZ, Claudio, CH-2300 La Chaux-de-Fonds (CH)
(74) Mandataire: P&TS Patents & Technology Surveys SA
(86) Numéro de dépôt international: PCT/CH2003/000321
(87) Numéro de publication internationale: WO 2003/107731

(56) Documents cités:
- EP-A- 0 534 455
- US-A- 4 809 430
- US-A- 4 858 308
- US-B1- 6 195 878

## Description

La présente invention concerne une méthode permettant l'ajustement des supports de porte-composants d'un barillet de convoyeur de composants électroniques, ainsi qu'un barillet permettant l'exécution de la méthode.

Au cours de leur fabrication, de leur conditionnement ou avant leur intégration sur un circuit imprimé, les composants électroniques subissent généralement une succession d'opérations, par exemple des tests électriques, le long d'une chaîne de production souvent entièrement automatisée. Les composants électroniques sont ainsi transférés d'un poste de traitement à un autre par un convoyeur, qui peut être par exemple linéaire ou circulaire.

Un barillet est l'élément central d'un convoyeur circulaire, autour duquel sont définis plusieurs emplacements de postes de traitement régulièrement espacés. Chacun de ces emplacements est généralement occupé par un poste de traitement effectuant une ou plusieurs opérations sur les composants électroniques qui lui sont présentés. Dans certains cas, un poste de traitement peut occuper plusieurs emplacements. L'ensemble des postes de traitement disposés autour du barillet forme ainsi un cycle d'opérations successives, par exemple de tests électriques ou mécaniques, d'opérations de conditionnement, etc., auquel les composants électroniques convoyés sur le barillet sont soumis. Le premier poste de traitement du cycle est généralement un poste d'entrée dont le rôle consiste essentiellement à amener les composants électroniques, depuis un réservoir ou depuis un autre convoyeur, sur le barillet. Le cycle peut comprendre un ou plusieurs postes de sortie, permettant ainsi de sortir les composants à différentes étapes du cycle, par exemple en fonction de caractéristiques mesurées sur un précédent poste de test.

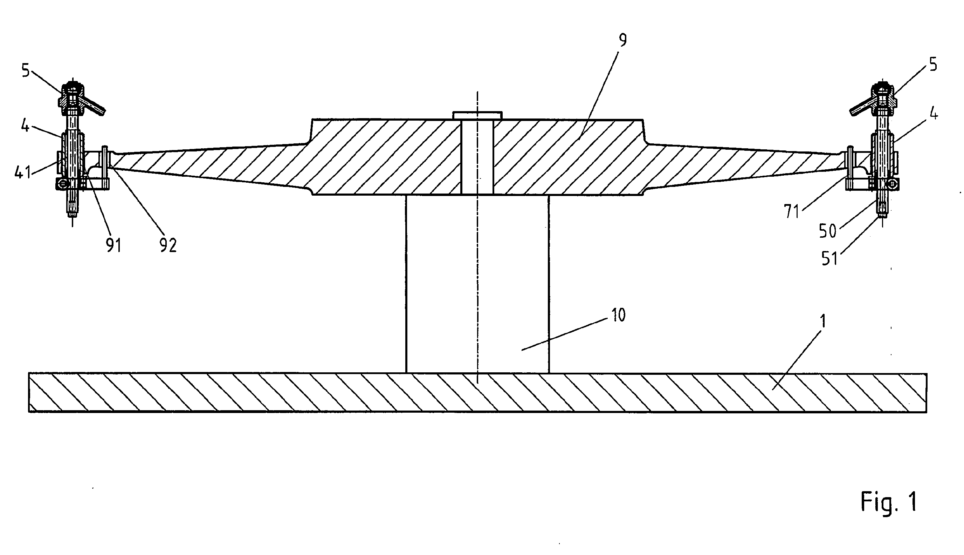

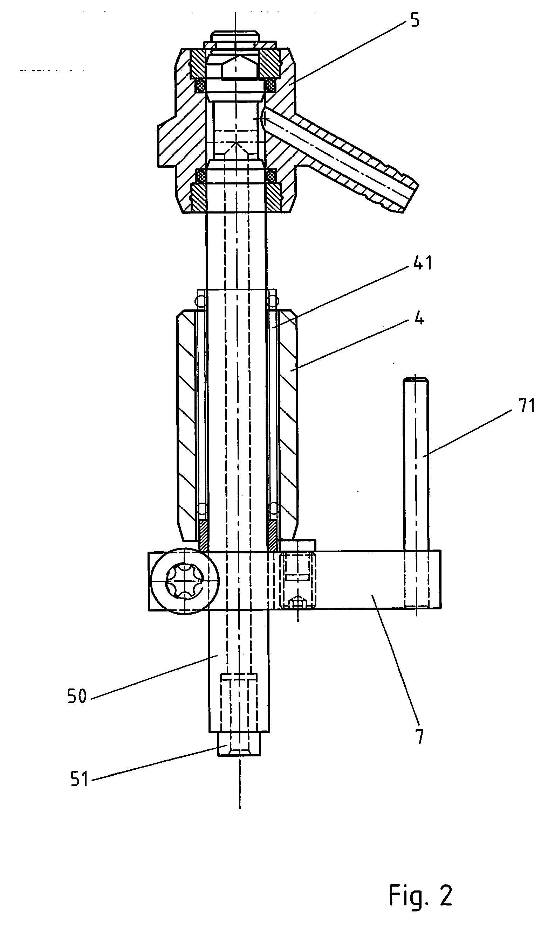

En référence aux figures 1 et 2, le barillet 9 est équipé de supports de porte-composants, généralement des douilles 4, dans lesquels sont insérés des porte-composants 5 servant à prélever ou à recevoir les composants électroniques depuis les différents postes de traitement, à les maintenir durant le mouvement du barillet et, le cas échéant, à les présenter au poste de traitement suivant. Les douilles 4 sont régulièrement réparties sur le barillet 9, sur un cercle proche de sa périphérie, selon une disposition correspondant à celle des emplacements définis autour du barillet 9. Au cours d'une rotation de 360° autour de son centre, le barillet 9 possède ainsi un nombre fini de pas auxquels chaque douille 4 se retrouve face à un emplacement pour poste de traitement. Le barillet 9 et les postes de traitement sont généralement solidaires d'une même plaque de base 1, garantissant ainsi le maintien de leurs positions relatives.

Le barillet 9 est souvent monté directement sur un moteur rotatif 10 fixé sur la plaque de base 1. Le barillet 9 est tourné autour de son centre par le moteur 10 en de courts et rapides mouvements de rotation suivis de moments d'arrêts à chaque pas.

Avant chaque mouvement de rotation, les porte-composants 5 insérés dans leurs supports 4 prélèvent ou reçoivent le composant se trouvant sur le poste de traitement face à eux. La position du barillet est ensuite indexée d'un pas. Durant le mouvement du barillet, les composants prélevés par les porte-composants 5 sont maintenus par ces derniers sur le barillet 9. Après indexation de la position du barillet, chaque porte-composant 5 se retrouve face à l'emplacement suivant, qui est généralement équipé du prochain poste de traitement du cycle. Le composant est alors mis à disposition du poste de traitement qui effectue l'opération pour laquelle il est conçu. Durant la phase de traitement, le barillet est généralement immobilisé. Les étapes décrites ci-dessus sont répétées, le convoyeur transférant ainsi successivement chaque composant d'un poste de traitement au suivant, jusqu'à ce que tous les composants à traiter aient été soumis à un cycle d'opérations.

Dans la majorité des cas, les porte-composants 5 du barillet comprennent une buse 51 prélevant et maintenant les composants électroniques par vide d'air. D'autres systèmes sont toutefois possibles, par exemple des systèmes mécaniques de préhension, par exemple des pinces, ou des réceptacles sur lesquels les composants sont déposés par chaque poste de traitement et d'où ils sont prélevés par le poste de traitement suivant. Quel que soit le type de porte-composants choisi, ils sont installés sur le barillet 9 après la fabrication complète de ce dernier, généralement sur des supports de porte-composants, par exemple des douilles 4, eux-mêmes fixés au barillet 9 dans des profils 91 adaptés. Dans la plupart des systèmes de l'art antérieur, les douilles sont chassées dans des trous usinés à la périphérie du barillet.

Dans l'exemple illustré par les figures 1 et 2, les porte-composants 5 possèdent une partie cylindrique allongée 50 qui est insérée dans la douille 4 correspondante. Pour faciliter l'insertion du porte-composant et pour garantir sa bonne tenue dans la douille, un système de roulements à billes 41 est glissé entre la douille 4 et le porte-composant 5. La position du porte-composant 5 dans l'axe de la douille 4 est ajustée de manière à ce que la buse soit à la hauteur désirée. Une bague 7 est ensuite glissée autour de la partie cylindrique 50 du porte-composant 5 jusqu'à arriver en butée contre la douille 4. La bague 7 comporte une tige 71 qui est insérée dans un trou auxiliaire 92, évitant ainsi, après serrage de la bague 7 sur la partie cylindrique 50 du porte-composant 5, toute rotation indésirable du porte-composant 5 dans la douille 4. La douille 4, le porte-composant 5, ses éléments de blocage 7, 71 et leur interaction avec les profils du barillet 91 et 92 sont détaillés ci-dessus à titre d'exemple. Les convoyeurs de composants électroniques peuvent faire appel à des mécanismes fort divers afin d'attacher les porte-composants au barillet 9.

L'évolution continue des technologies dans le domaine des semiconducteurs conduit à une réduction générale de la taille des composants électroniques, requérant ainsi une plus grande précision des systèmes de traitement de ces composants, ainsi qu'une miniaturisation des éléments de manipulation de ces systèmes.

Dans le cas d'un barillet, cela implique, outre un contrôle précis des mouvements pas à pas du barillet et une diminution, par exemple, de la taille des buses des porte-composants, une précision toujours plus grande dans la fabrication des diverses pièces du système et dans l'ajustement de leurs positions relatives.

Le document US 6195878 décrit un système de montage de composants électroniques comprenant un convoyeur circulaire à la périphérie duquel se trouvent des têtes de montage. Ces têtes de montage comprennent plusieurs buses d'aspiration dont la position peut prendre plusieurs valeurs discrètes et s'adapter ainsi à celle des composants à saisir.

Dans les systèmes de l'art antérieur, les profils destinés à recevoir les supports de porte-composants, par exemple les trous dans lesquels seront chassées les douilles, sont usinés lors de la fabrication du barillet. De la précision de leur emplacement et de leurs dimensions dépendra ainsi en grande partie la précision, dans le système fini, de l'alignement du support, et par conséquent du porte-composant, avec les emplacements des postes de traitement définis autour du barillet. Le montage du système commence généralement par le centrage et la fixation du barillet sur le moteur, lui-même préalablement centré sur la plaque de base, par rapport aux emplacements définis autour de lui. Les postes de traitement sont ensuite fixés sur la plaque de base, dans une position la plus précise possible par rapport à la position du barillet.

Un tel système possède d'importantes limitations quant à la précision de montage. En effet, une légère erreur dans le centrage du barillet peut conduire à d'importantes imprécisions dans le positionnement des douilles, et donc des porte-composants, par rapport aux postes de traitement. Les méthodes connues de calcul d'erreur nous apprennent en particulier que l'erreur totale sur la position des douilles par rapport aux emplacements des postes de traitement est égale à l'addition des erreurs à chaque étape de fabrication ou de montage, soit l'erreur sur le centrage et les dimensions des profils destinés à recevoir les supports de porte-composants lors de la fabrication du barillet, l'erreur sur le centrage du moteur sur la plaque de base, l'erreur sur le centrage du barillet sur le moteur, l'erreur sur les dimensions du support de porte-composant et l'erreur sur son positionnement sur le profil destiné à le recevoir. De plus, un tel système ne permet pas la correction d'une erreur sur l'emplacement ou les dimensions d'un seul profil, survenue par exemple lors de la fabrication du barillet.

Un des buts de la présente invention est donc de proposer une méthode d'ajustement permettant d'obtenir une augmentation significative de la précision d'alignement des porte-composants du barillet par rapport aux postes de traitement.

Ce but est atteint par une méthode et un barillet selon les revendications indépendantes correspondantes, des variantes d'exécution étant décrites par les revendications dépendantes.

En particulier, ce but est atteint par une méthode permettant l'ajustement individuel de chaque support de porte-composant du barillet, de préférence après que le barillet est monté sur la plaque de base.

En particulier, ce but est atteint par une méthode pour l'ajustement de la position des supports de porte-composants d'un barillet, ladite méthode comprenant :
1) l'ajustement de la position d'un support de porte-composant sur le barillet dans une position de référence,
2) le blocage du support dans cette position,

La présente invention sera mieux comprise à l'aide de la description de sa variante préférentielle donnée à titre d'exemple, illustrée à l'aide des figures 1 à 5.
La figure 1 détaillée précédemment illustre un système de convoyage circulaire comprenant un barillet.
La figure 2 détaillée précédemment illustre un exemple de porte-composant.
La figure 3 montre un barillet et sa position relative au poste d'étalonnage utilisé dans une version préférentielle de la méthode.
La figure 4 montre le poste d'étalonnage utilisée dans une version préférentielle de l'invention et son interaction avec le support de porte-composant à ajuster.
La figure 5 montre une portion de la périphérie d'un barillet adapté à l'exécution d'une autre variante préférentielle de l'invention.
La figure 6 montre une coupe d'un des doigts de la figure 5.

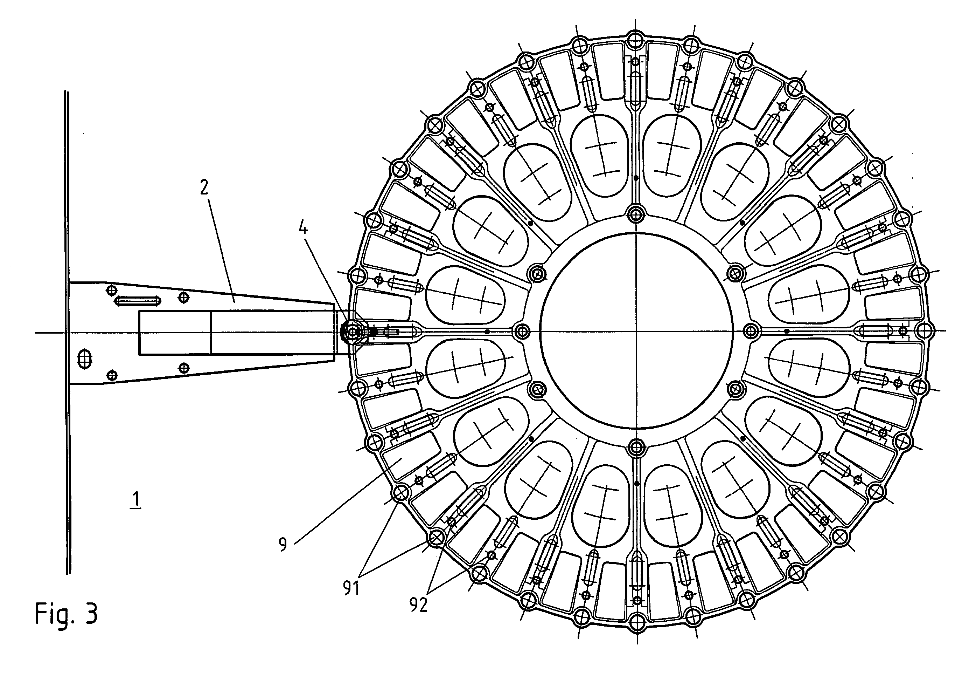

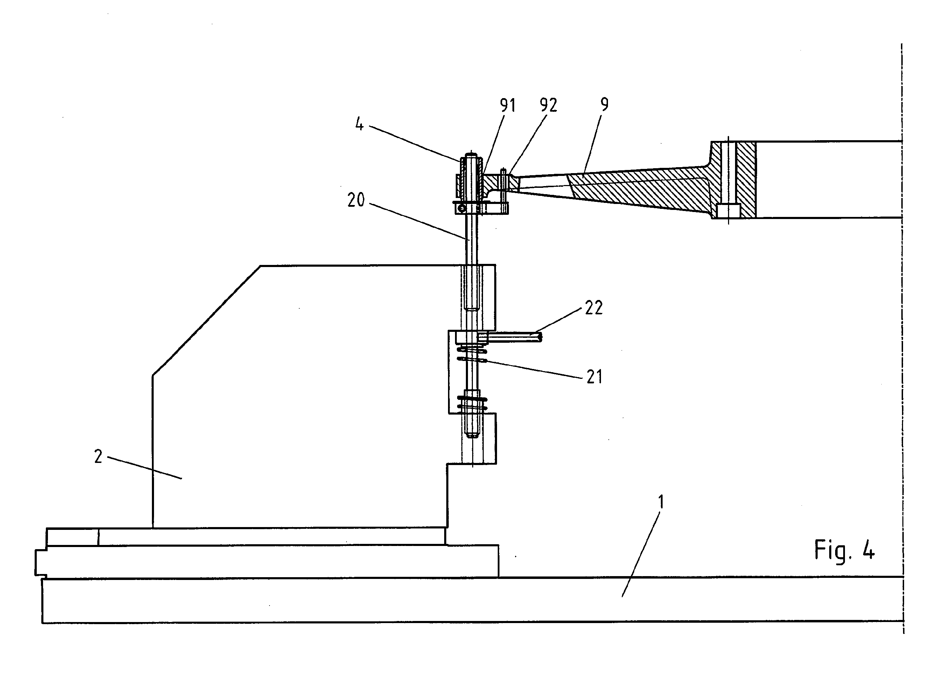

Dans une version préférentielle dont les éléments principaux sont illustrés dans les figures 3 et 4, la présente invention est appliquée à un barillet 9 dont les supports de porte-composants sont des douilles 4 fixées dans des trous 91 répartis régulièrement sur un cercle proche de la périphérie du barillet 9. Lors de l'assemblage du système, le barillet 9 est fixé en rotation sur une plaque de base 1. Avant sa fixation complète, sa position est ajustée de manière à ce qu'il soit le plus centré possible par rapport aux emplacements prévus sur la plaque de base pour les postes de traitement. Au moins un de ces emplacements est provisoirement occupé par un poste d'étalonnage 2 définissant une position de référence pour l'ajustement de la position des douilles 4.

Dans sa version préférentielle, le poste d'étalonnage 2 utilisé pour l'exécution de cette version préférentielle de la méthode inventive est maintenu par son socle, de préférence vissé, sur la plaque de base 1. Il comporte une tige calibrée 20 d'un diamètre proche du diamètre intérieur des douilles 4. La tige calibrée 20 est maintenue vers le haut sous l'action d'un ressort 21, dans l'axe selon lesquelles les douilles 4 devront être orientée, généralement verticalement par rapport à la plaque de base 1. La tige de référence 20 peut être tirée vers le bas à l'aide d'une goupille 22.

Le barillet 9 est orienté de manière à ce qu'un premier trou 91 soit positionné au dessus de la tige de référence 20, tandis que cette dernière est maintenue vers le bas. La tige de référence 20 est remontée dans le trou 91 et une douille 4 est glissée le long de la tige de référence 20 à l'intérieur du trou 91. Sur la tige de référence est fixée une bague similaire aux bagues 7 utilisées pour bloquer les porte-composants 5, permettant ainsi de déterminer avec précision la position de la douille 4 à ajuster sur l'axe de la tige de référence. Le diamètre du trou 91 est sensiblement plus grand que le diamètre extérieur de la douille 4 afin de laisser à cette dernière une certaine liberté permettant ainsi l'ajustement de sa position. La rotation du barillet 9 peut être légèrement corrigée afin de centrer autant que possible le trou 91 autour de la douille 4 maintenue par la tige de référence 20. La position du barillet après correction est de préférence enregistrée par le système de commande du moteur comme position de référence du système d'indexation. Un matériau durcissant, par exemple de la colle, du mastic, de la résine, etc., est alors coulé dans l'espace entre le trou 91 et la douille 4 afin, en durcissant, de fixer la douille 4 au barillet 9.

Une fois que le matériau durcissant est suffisamment dur pour que la douille 4 soit fermement maintenue en position, la tige de référence 20 est à nouveau tirée vers le bas à l'aide de la goupille 22. Le moteur 10 est activé afin de faire tourner le barillet 9 d'un certain nombre de pas, jusqu'à ce qu'un nouveau trou 91 soit positionné au-dessus de la tige de référence 20. La tige de référence 20 est relevée et insérée dans le trou 91. Une douille 4 est glissée le long de la tige de référence 20 dans le trou 91 et du matériau liquide durcissant est coulé dans l'espace entre le trou 91 et la douille 4. Lorsque le matériau durcissant est suffisamment dur, la tige de référence 20 est à nouveau retirée de la douille 4 pour permettre le mouvement du barillet 9 jusqu'à présentation d'un nouveau trou 91 face au poste d'étalonnage 2.

Les étapes d'ajustement décrites ci-dessus sont répétées jusqu'à l'ajustement individuel de chaque douille 4 dans chaque trou 91 du barillet 9. Une fois toutes les douilles 4 individuellement ajustées et fixées sur le barillet 9, les porte-composants 5 peuvent être posés sur le barillet, par exemple selon le principe décrit plus haut et illustré par les figures 1 et 2.

Grâce à la méthode selon l'invention, la position de chaque douille 4 est ainsi individuellement ajustée par rapport à une position de référence correspondant à la position future des éléments récepteurs et/ou de sortie des postes de traitement qui seront installés autour du barillet 9. L'erreur possible sur la position de la douille 4 est ainsi uniquement déterminée par l'erreur possible lors de l'ajustement de cette position par rapport au poste d'étalonnage 2. Une telle méthode permet ainsi de compenser, voire corriger totalement des erreurs ou imprécisions survenues lors des étapes précédentes, par exemple lors du centrage du barillet ou lors de l'usinage des trous 91 dans le barillet 9, etc.

Chaque poste de traitement installé autour du barillet 9 est ensuite individuellement positionné avec précision de manière à aligner ses éléments de réception et/ou de sortie des composants avec la position des porte-composants 5. Sur le système fini, la précision de l'alignement entre les porte-composants 5 et les postes de traitement ne dépend ainsi que de la précision de l'ajustement des douilles 4 et de la précision de l'alignement de chaque poste de traitement.

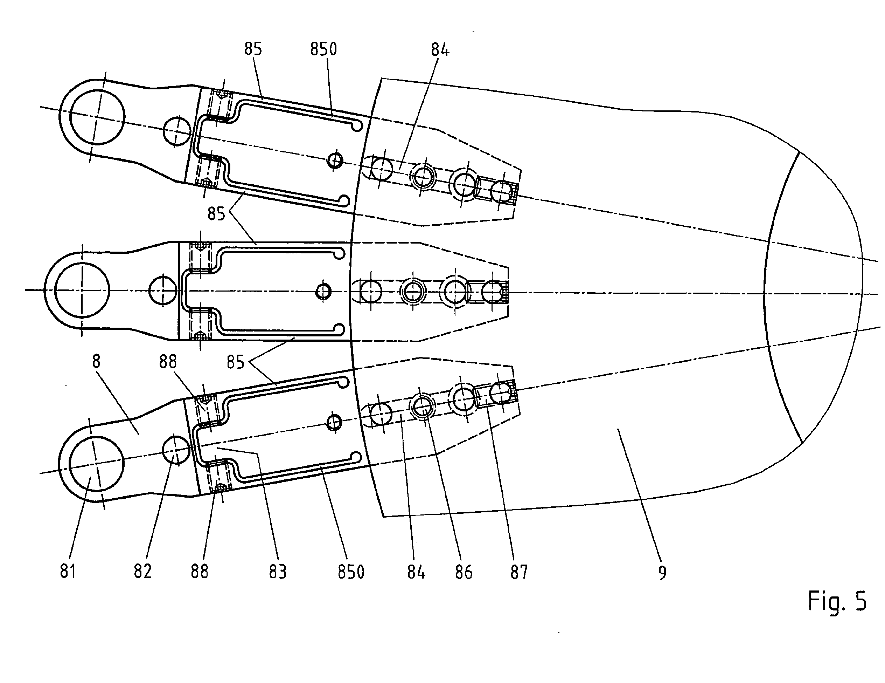

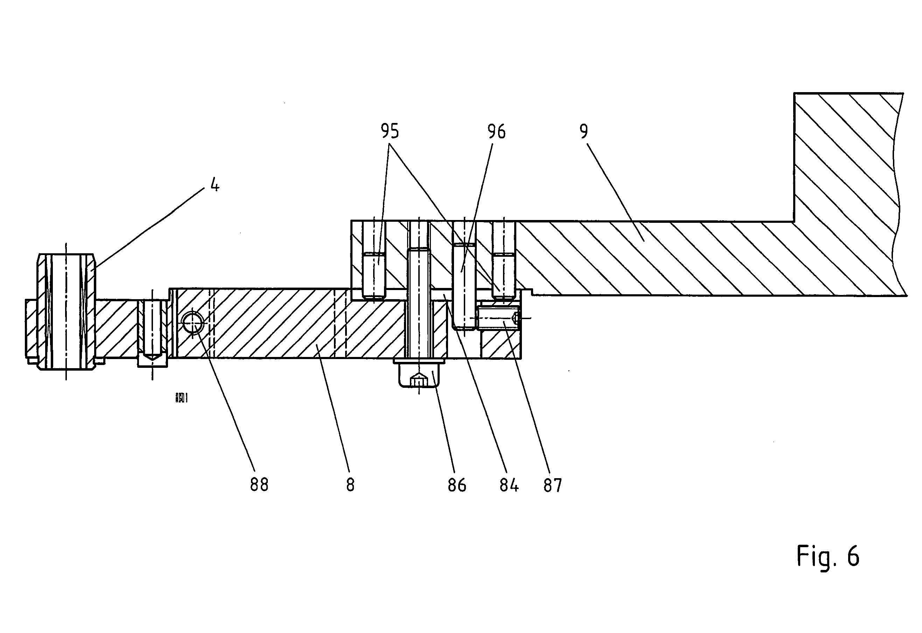

Selon une autre variante préférentielle, la méthode inventive est appliquée à un barillet 9, illustré par les figures 5 et 6, comprenant des doigts réglables 8 répartis régulièrement sur sa périphérie et destinés à recevoir les supports de porte-composants. Les supports de porte-composants, en l'occurrence les douilles 4, sont chassés dans des trous 81, sans possibilité d'ajustement de leur position par rapport au doigt réglable 8. De préférence, chaque doigt réglable 8 ne comporte qu'une seule douille 4.

Le doigt réglable 8 est fixé au barillet 9 par une vis 86. Des goupilles 95 sont glissées à travers des orifices prévus à cet effet sur le barillet 9 et une de leurs extrémités est glissée dans un guide 84 pratiqué sur la face du doigt réglable 8 orientée contre le barillet 9, maintenant ainsi à ce dernier dans une position sensiblement radiale par rapport au centre du barillet 9. Une goupille supplémentaire 96 est chassée dans un trou traversant le barillet 9 et sert d'appui à la vis de réglage radiale 87 dont la fonction est décrite plus tard. Le doigt réglable 8 comporte une encoche 850 dont la forme définit un profil rigide 83 et deux lamelles flexibles 85. La position du profil rigide est fixe par rapport à la partie du doigt réglable 8 fixé au barillet 9. Les lamelles flexibles 85 permettent en revanche le mouvement de l'extrémité du doigt réglable 8 sur laquelle se trouve la douille 4 par rapport à la partie rigide 83, sous l'action des vis de réglage tangentielles 88.

Lors de l'assemblage du système, le barillet 9 équipé de ses doigts réglables 8 est de préférence fixé en rotation sur le moteur 10 précédemment attaché à la plaque de base 1 et est centré sur cette dernière par rapport aux emplacements prévus pour les postes de traitement.

Un poste d'étalonnage non représenté est installé sur un des emplacements de poste de traitement. Le poste d'étalonnage est de préférence un système optique comprenant une caméra visant avec précision dans l'axe sur lequel les douilles 4 doivent être centrées. Le signal de la caméra est visualisé sur un écran de contrôle et est superposé à une mire déterminant avec précision le centre de l'image. La superposition, sur l'écran de contrôle, de l'image de la douille 4 filmée par la caméra et de la mire permet ainsi de déterminer l'alignement de la douille 4 par rapport à l'axe de référence.

Dans une autre variante de la méthode, le poste d'étalonnage non représenté comprend deux comparateurs mécaniques orientés perpendiculairement entre eux et perpendiculairement à l'axe de référence sur lequel la douille 4 doit être centrée. Les comparateurs sont amenés, dans une position de référence, en contact par exemple avec la surface extérieure de la douille 4 à ajuster ou avec la surface extérieure d'une goupille calibrée insérée dans la douille 4. Les déviations de la position de cette surface le long des axes des comparateurs par rapport à une position de référence peuvent être ainsi mesurées avec précision, permettant de contrôler l'ajustement parfait de la douille 4 sur l'axe de référence.

L'homme du métier comprendra que, outre les deux méthodes citées ci-dessus à titre d'exemple, il est parfaitement envisageable d'utiliser d'autres méthodes pour déterminer le centrage de la douille sur l'axe de référence.

Afin d'ajuster la position de la douille 4 dans la direction radiale par rapport au centre du barillet 9, la vis 86 est légèrement dévissée, puis la vis de réglage radiale 87 est tournée soit dans le sens des aiguilles d'une montre pour éloigner le doigt réglable 8, et donc la douille 4, du centre du barillet 9, soit dans le sens inverse des aiguilles d'une montre pour permettre son rapprochement du centre du barillet 9. La position radiale du doigt réglable 8 est ainsi ajustée jusqu'à ce que le centre de la douille 4 se trouve à la distance voulue par rapport au centre du barillet 9. La vis de fixation 86 est ensuite bloquée afin de maintenir le doigt réglable 8 dans la position ajustée.

La position de la douille 4 selon la direction tangente au barillet 9 est ajustée grâce aux vis de réglage tangentielles 88 qui appuient sur les deux faces opposées du profil rigide 83 au centre de la découpe 850. En modifiant la pression relative des deux vis de réglage tangentielles 88 sur le profil rigide 83, la position de l'extrémité du doigt réglable 8, et par conséquent la position de la douille 4, est modifiée grâce à la flexion des lamelles 85.

Une fois la douille 4 centrée sur l'axe de référence déterminé par le poste d'étalonnage, le moteur 10 est activé afin de faire tourner le barillet 9 d'un certain nombre de pas, jusqu'à amener un nouveau doigt réglable 8 à ajuster face au poste d'étalonnage. Les étapes de réglage décrites ci-dessus sont ensuite répétées jusqu'à l'ajustement de tous les doigts réglables 8 du barillet 9. Une fois la position de toutes les douilles 4 individuellement ajustée et bloquée sur le barillet 9, les porte-composants 5 peuvent être fixés sur le barillet 9, par exemple selon le principe décrit plus haut et illustré par les figures 1 et 2.

Grâce à la méthode selon l'invention, la position de chaque douille 4 est ainsi individuellement ajustée par rapport à une position de référence correspondant à la position future des éléments récepteurs et/ou de sortie des postes de traitement qui seront installés autour du barillet 9. L'erreur possible sur la position de la douille 4 est ainsi uniquement déterminée par l'erreur possible lors de l'ajustement de cette position par rapport au poste d'étalonnage 2. Une telle méthode permet ainsi de compenser, voire corriger totalement des erreurs ou imprécisions survenues lors des étapes précédentes, par exemple lors du centrage du barillet ou lors de l'usinage des trous 81 dans les doigts réglables 8, etc.

Bien que les moyens d'ajustement du doigt réglable 8 décrits ci-dessus soient conçus pour l'ajustement de la position de la douille 4 selon deux axes dans un plan horizontal par rapport à la plaque de base 1, l'homme du métier comprendra qu'il est parfaitement envisageable de compléter ou de modifier ces moyens d'ajustement afin, par exemple, de pouvoir également ajuster la position de la douille dans un plan vertical ou selon tout autre axe.

Chaque poste de traitement installé autour du barillet est ensuite individuellement positionné avec précision de manière à aligner ses éléments de réception et/ou de sortie des composants avec la position des porte-composants. Sur le système fini, la précision de l'alignement entre les porte-composants et les postes de traitement ne dépend ainsi que de la précision de l'ajustement des douilles et de la précision de l'alignement de chaque poste de traitement.

La méthode inventive, détaillée ci-dessus pour deux variantes préférentielles données à titre d'exemples illustratifs mais non limitatifs, permet de compenser, grâce à l'ajustement individuel de chaque support de porte-composant par rapport à une position de référence unique, de compenser les erreurs ou imprécisions survenues dans les étapes précédentes de la fabrication ou de l'assemblage du système, telles que par exemple des imprécisions lors de l'usinage des profils destinés à accueillir les supports de porte-composants, des erreurs de centrage du barillet par rapport aux emplacements prévus pour les postes de traitement, etc.

Bien que, dans les variantes préférentielles de la méthode inventive décrites plus haut, l'ajustement de chaque support de porte-composant soit fait individuellement, l'homme du métier comprendra qu'il est également possible de mettre en oeuvre la méthode inventive de façon à pouvoir ajuster simultanément la position de plusieurs supports de porte-composants, par exemple par l'utilisation simultanée de plusieurs postes d'étalonnage, par l'utilisation de postes d'étalonnage comprenant plusieurs positions de référence correspondant aux positions de plusieurs douilles à ajuster, contiguës ou non, etc. Si elle permet une diminution du temps nécessaire à l'ajustement de l'ensemble des supports de porte-composants du barillet, cette variante de la méthode inventive présente toutefois plus de possibilités d'imprécision dans l'ajustement, notamment par d'éventuelles erreurs dans les positions relatives des différentes positions de référence.

Il est également possible pour l'homme du métier d'appliquer la méthode selon l'invention et d'adapter les moyens d'ajustement pour l'ajustement de la position des supports de portes-composants sur le barillet selon d'autres axes que ceux cités dans les exemples ci-dessus, par exemple selon un axe vertical par rapport à la plaque de base 1 ou selon un axe de rotation, par exemple vertical ou horizontal.

## Revendications

1. Méthode pour l'ajustement de la position de supports de porte-composants (4) sur un barillet (9) de convoyeur de composants électroniques, ladite méthode comprenant :
1) l'ajustement de la position d'au moins un desdits supports de porte-composants (4) sur ledit barillet (9) dans une position de référence déterminée,
2) le blocage dudit au moins un desdits supports de porte-composants (4) dans ladite position de référence.

2. Méthode selon la revendication précédente, ledit barillet (9) étant précédemment fixé en rotation sur une plaque de base (1) par l'intermédiaire d'un socle.

3. Méthode selon la revendication précédente, comprenant ultérieurement
3) la rotation dudit barillet (9) d'un nombre fini de fractions de tour complet,
4) l'ajustement de la position d'au moins un autre desdits supports de porte-composants (4) sur ledit barillet (9) dans une position de référence déterminée,
5) le blocage dudit au moins un autre desdits supports de porte-composants (4) dans ladite position de référence,
6) la répétition des points 3), 4) et 5) jusqu'à l'ajustement et au blocage de tous lesdits supports de porte-composants (4).

4. Méthode selon l'une des revendications précédentes, ladite position de référence étant déterminée à l'aide de moyens mécaniques.

5. Méthode selon la revendication précédente, lesdits moyens mécaniques étant une tige de référence (20).

6. Méthode selon la revendication 4, lesdits moyens mécaniques étant des comparateurs.

7. Méthode selon l'une des revendications 1 ou 2, ladite position de référence étant déterminée à l'aide de moyens optiques.

8. Méthode selon l'une des revendications précédentes, ledit au moins un desdits supports de porte-composants (4) étant bloqué dans ladite position de référence à l'aide d'un matériau durcissant.

9. Méthode selon l'une des revendications 1 à 6, ledit au moins un desdits supports de porte-composants (4) étant bloqué dans ladite position de référence à l'aide de moyens d'ajustement mécaniques (86, 87, 88).

10. Méthode selon l'une des revendications précédentes, les positions de référence d'une pluralité desdits supports de porte-composants (4) étant déterminées simultanément.

11. Barillet de convoyeur de composants électroniques comprenant sur sa périphérie des supports de porte-composants (4), **caractérisé en ce que** la position de chacun desdits supports de porte-composants (4) peut être ajustée et bloquée individuellement dans une position déterminée lors du montage du convoyeur sans usinage dudit barillet (9).

12. Barillet selon la revendication précédente, lesdits supports de porte-composant (4) étant des douilles (4).

13. Barillet selon l'une des revendications précédentes, la position de chacun desdits supports de porte-composants (4) étant ajustable à l'aide de moyens d'ajustement mécaniques (87, 88).

14. Barillet selon la revendication précédente, les moyens d'ajustement mécaniques comportant des vis de réglage (87, 88).

15. Barillet selon l'une des revendications précédentes, lesdits supports de porte-composants (4) étant collés sur le barillet (9).

16. Barillet selon l'une des revendications précédentes, lesdits supports de porte-composants (4) étant répartis sur des doigts réglables (8) fixés à la périphérie dudit barillet (9).

17. Barillet selon la revendication précédente, lesdits doigts réglables (8) comportant une encoche (850) permettant la flexion desdits doigts réglables (8) selon au moins un axe.

18. Barillet selon l'une des revendications précédentes, ladite position de chacun desdits supports de porte-composants (4) pouvant être ajustée selon au moins deux axes indépendants.

19. Barillet selon la revendication précédente, ladite position de chacun desdits supports de porte-composants (4) pouvant être ajustée selon au moins trois axes indépendants.

## Claims

1. Method for adjusting the position of component-holder supports (4) on a barrel (9) for a conveyor of electronic components, said method comprising:
1) adjusting the position of at least one of said component-holder supports (4) on said barrel (9) in a determined reference position,
2) blocking said at least one of said component-holder supports (4) in said reference position.

2. Method according to the preceding claim, said barrel (9) being previously fastened in rotation on a base plate (1) through the intermediary of a base.

3. Method according to the preceding claim, comprising subsequently
3) rotating said barrel (9) by a finite number of fractions of a complete turn,
4) adjusting the position of at least one other of said component-holder supports (4) on said barrel (9) in a determined reference position,
5) blocking said at least one other of said component-holder supports (4) in said reference position,
6) repeating points 3), 4) and 5) until all said component-holder supports (4) have been adjusted and blocked.

4. Method according to one of the preceding claims, said reference position being determined through mechanical means.

5. Method according to the preceding claim, said mechanical means being a reference rod (20).

6. Method according to claim 3, said mechanical means being comparators.

7. Method according to one of the claims 1 or 2, said reference position being determined through optical means.

8. Method according to one of the preceding claims, said at least one of said component-holder supports (4) being blocked in said reference position by means of a hardening material.

9. Method according to one of the claims 1 to 6, said at least one of said component-holder supports (4) being blocked in said reference position through mechanical adjusting means (86, 87, 88).

10. Method according to one of the preceding claims, the reference positions of plurality of component-holder supports (4) being determined simultaneously.

11. Barrel for a conveyor of electronic components, comprising on its periphery component-holder supports (4), **characterized in that** the position of each of said component-holder supports (4) can be adjusted and blocked individually in a determined position during assembly of the conveyor without machining said barrel (9).

12. Barrel according to the preceding claim, said component-holder supports (4) being bushings (4).

13. Barrel according to one of the preceding claims, the position of each of said component-holder supports (4) being adjustable through mechanical adjusting means (87, 88).

14. Barrel according to the preceding claim, the mechanical adjusting means comprising adjusting screws (87, 88).

15. Barrel according to one of the preceding claims, said component-holder supports (4) being glued to the barrel (9).

16. Barrel according to one of the preceding claims, said component-holder supports (4) being spread on adjustable fingers (8) fastened at the periphery of said barrel (9).

17. Barrel according to the preceding claim, said adjustable fingers (8) comprising a notch (850) allowing the flexion of said adjustable fingers (8) along at least one axis.

18. Barrel according to one of the preceding claims, said position of each of said component-holder supports (4) being capable of being adjusted along at least two independent axes.

19. Barrel according to the preceding claim, said position of each of said component-holder supports (4) being capable of being adjusted along at least three independent axes.

## Patentansprüche

1. Verfahren um die Position von Bauteilträgern (4) an einer Trommel (9) für ein Förderband von elektronischen Komponenten anzupassen, besagtes Verfahren umfasst
1) Einstellen der Position von mindestens einem der besagten Bauteilträgern (4) an einer Trommel (9) in einer bestimmten Referenzposition,
2) Blockieren von besagtem mindestens einem der besagten Bauteilträgern (4) in besagter Referenzposition.

2. Verfahren gemäss dem vorhergehenden Anspruch, wobei besagte Trommel (9) vorher in Rotierung auf einer Grundplatte (1) durch das Mittel einer Basis befestigt wird.

3. Verfahren gemäss dem vorhergehenden Anspruch, umfassend nachträglich
3) Rotieren besagter Trommel (9) in einer endlichen Anzahl von Anteilen einer ganzen Umdrehung,
4) Einstellen der Position von mindestens einer anderen der besagten Bauteilträgern (4) auf besagter Trommel (4) in einer bestimmten Referenzposition,
5) Blockieren von besagtem mindestens einem anderen der besagten Bauteilträgern (4) in besagter Referenzposition.
6) Wiederholen der Punkte 3), 4), 5) bis alle Bauteilträger (4) angepasst und blockiert wurden.

4. Verfahren gemäss einem der vorhergehenden Ansprüche, wobei besagte Referenzposition durch mechanische Mittel bestimmt wird.

5. Verfahren gemäss dem vorhergehenden Anspruch, wobei besagte mechanische Mittel ein Referenzrohr (20) ist.

6. Verfahren gemäss Anspruch 4, wobei besagte mechanische Mittel Komparatoren sind.

7. Verfahren gemäss einem der Ansprüche 1 bis 2, wobei besagte Referenzposition durch optische Mittel bestimmt wird.

8. Verfahren gemäss einem der vorhergehenden Ansprüche, wobei besagter mindestens einer von besagten Bauteilträgern (4) in besagter Referenzposition durch ein gehärtetes Material blockiert wird.

9. Verfahren gemäss einem der Ansprüche 1 bis 6, wobei besagter mindestens einer von besagten Bauteilträgern (4) in besagter Referenzposition durch mechanische Einstellungssmittel (86, 87, 88) blockiert wird.

10. Verfahren gemäss einem der vorhergehenden Ansprüche, wobei die Referenzposition von einer Vielzahl von Bauteilträgern (4) gleichzeitig bestimmt wird.

11. Trommel für ein Förderband von elektronischen Komponenten, umfassend auf seinem Umfang Bauteilträger (4), **gekennzeichnet dadurch, dass** die Position von jedem der besagten Bauteilträger (4) einzeln in einer bestimmten Position während dem Zusammenbau des Förderbands angepasst und blockiert werden kann, ohne besagte Trommel (9) zu bearbeiten.

12. Trommel gemäss dem vorhergehenden Anspruch, wobei besagte Bauteilträger (4) Hülsen sind.

13. Trommel gemäss einem der vorgehenden Ansprüche, wobei die Position von jedem der besagten Bauteilträger (4) durch mechanische Einstellmittel (87, 88) einstellbar sind.

14. Trommel gemäss dem vorhergehenden Anspruch, wobei die mechanischen Einstellmittel Einstellschrauben (87, 88) umfassen.

15. Trommel gemäss einem der vorgehenden Ansprüche, wobei besagte Bauteilträger (4) an die Trommel (9) geklebt sind.

16. Trommel gemäss einem der vorgehenden Ansprüche, wobei besagte Bauteilträger (4) auf einstellbaren Fingern (8) verteilt sind, die an dem Rand der Trommel (9) angebracht sind.

17. Trommel gemäss dem vorhergehenden Anspruch, wobei wobei besagte einstellbare Finger (8) eine Kerbe (850) umfassen, die die Biegung des flexiblen Fingers (8) entlang mindestens einer Achse erlaubt.

18. Trommel gemäss einem der vorgehenden Ansprüche, wobei besagte Position von jedem der besagten Bauteilträger (4) fähig ist, entlang mindestens zwei unabhängigen Achsen angepasst zu werden.

19. Trommel gemäss dem vorhergehenden Anspruch, wobei besagte Position von jedem der besagtem Bauteilträger (4) fähig ist, entlang mindestens drei unabhängigen Achsen angepasst zu werden.
